Europäisches Patentamt

(19) European Patent Office

Office européen des brevets

(11) Veröffentlichungsnummer: **0 212 735**
**B1**

(12) **EUROPÄISCHE PATENTSCHRIFT**

(45) Veröffentlichungstag der Patentschrift: **23.05.90**

(51) Int. Cl.⁵: **G 01 N 24/08**

(21) Anmeldenummer: **86201357.0**

(22) Anmeldetag: **01.08.86**

(54) Verfahren zum selektiven Anregen eines Volumens in einem Objekt.

(30) Priorität: **12.08.85 NL 8502223**

(43) Veröffentlichungstag der Anmeldung:
**04.03.87 Patentblatt 87/10**

(45) Bekanntmachung des Hinweises auf die
Patenterteilung:
**23.05.90 Patentblatt 90/21**

(84) Benannte Vertragsstaaten:
**CH DE FR GB IT LI**

(56) Entgegenhaltungen:
**EP-A-0 089 534**
**EP-A-0 144 871**
**GB-A-2 114 756**

**ELECTRO 78, CONFERENCE RECORD, Mai 1978,**
**Seiten 30/2: 1-15, Boston, US; CC.-M. LAI et al.:**
**"Nuclear magnetic resonance zeugmatography**
**for medical imaging"**

(73) Patentinhaber: **N.V. Philips'**
**Gloeilampenfabrieken**
**Groenewoudseweg 1**
**NL-5621 BA Eindhoven (NL)**

(72) Erfinder: **Luyten, Peter Rudolf**
**INT. OCTROOIBUREAU B.V. Prof. Holstlaan 6**
**NL-5656 AA Eindhoven (NL)**
Erfinder: **Den Hollander, Jan Anthonie**
**INT. OCTROOIBUREAU B.V. Prof. Holstlaan 6**
**NL-5656 AA Eindhoven (NL)**

(74) Vertreter: **Faessen, Louis Marie Hubertus et al**
**INTERNATIONAAL OCTROOIBUREAU B.V. 6**
**Prof. Holstlaan**
**NL-5656 AA Eindhoven (NL)**

Courier Press, Leamington Spa, England.

## Beschreibung

Die Erfindung betrifft ein Verfahren zum selektiven Anregen eines Volumens in einem Objekt, das in einem einheitlichen statischen Magnetfeld angeordnet wird, wonach elektromagnetische Hochfrequenzimpulse und Gradientenmagnetfelder zum selektiven Anregen des genannten Volumens erzeugt werden.

Ein derartiges Verfahren ist bekannt und beispielsweise im "Journal of Magnetic Resonance" 56, S. 350 ... 354 (1984) von W. P. Aue u.a., beschrieben. Beim beschriebenen Verfahren werden in Reihenfolge nacheinander ein Gradientenmagnetfeld in der x-Richtung, in der y-Richtung und in der z-Richtung angelegt, wobei jeweils bei Vorhandensein eines derartigen Gradientenmagnetfeldes ein zusammengesetzter Hochfrequenzimpuls erzeugt wird. Die zusammengesetzten Hf-Impulse enthalten aufeinanderfolgend je einen selektiven 45°-Impuls, einen breitbandigen 90°-Impuls und einen selektiven 45°-Impuls. Nach diesen drei zusammengesetzten Impulsen weist ein "würfelartiges" Volumen, dessen Lage, Orientierung und Grösse durch die Stärke des statischen, einheitlichen Magnetfeldes, durch die Gradientenstärke der angelegten Gradientenmagnetfelder und durch die Frequenz (das Frequenzband) der selektiven Hf-Impulse gegeben ist, eine Magnetisierung auf, die seiner Magnetisierung vor Beginn der selektiven Anregung entgegengesetzt ist (die in der Richtung des einheitlichen, statischen Magnetfeldes verlief). Das bekannte Verfahren hat den Nachteil, dass der nicht-selektive 90°-Hf-Impuls bei angelegtem Gradientenmagnetfeld erzeugt und eine sehr hohe Spitzenleistung haben muss. Die Erzeugung eines derartigen Hf-Impulses stellt hohe Anforderungen an den zu verwendenden Hf-Sender, was sich kostensteigernd auswirkt und somit nachteilig ist.

Das bekannte vorgenannte Verfahren hat einen weiteren Nachteil, weil die Benutzung eines sehr starken HF-Impulses gegen die zu stellenden Sicherheitsanforderungen verstösst (bei hohen Feldstärken über 0,5 T des statischen Feldes). Weiter beruht das Verfahren auf Summierungen von Rotationen von Magnetisierungen der Kernspins durch die verschiedenen Anregungsimpulse. Die Anregungsimpulse müssen im ausgewählten Volumen dieses Objekts bzw. im Rest des Objekts eine Gesamtrotation über einen Winkel von 540° bzw. 270° bewirken, was nicht ganz der Fall ist. Die Kernspins in der ausgewählten z-Schicht (Gradientenmagnetfeld Gz und zwei selektive 45°-Impulse) erfahren nämlich eine Gesamtrotation von 360° für die Dauer der drei zusammengesetzten Impulse (mit Ausnahme des Teilvolumens der zwei Orthogonalquerschnitte mit der y- und der x-Schicht). Gleiches gilt für die Kernspins in der ausgewählten z- und x-Schicht. Ein nach den drei zusammengesetzten Impulsen zu erzeugender 90°-Impuls zum Aufrufen eines zu messenden Resonanz- oder Kerninduktionssignals des ausgewählten würfelartigen Volumens ruft daher auch Rezonanzsignale (trotz der Phasenzerstreuung des Kernspins) aus den genannten Ebenen auf, was als äusserst störend empfunden wird.

Der Erfindung liegt die Aufgabe zugrunde, ein Verfahren anzugeben, mit dem einzig und allein ein gewünschtes Volumen auswählbar ist und wobei aus dem um das Volumen herum vorhandenen Stoff kein störender Signalbeitrag in einem zu erzeugenden Resonanzsignal empfangen wird.

Zur Lösung dieser Aufgabe ist ein erfindungsgemässes Verfahren dadurch gekennzeichnet, dass ein nicht-selektiver 90°-Impuls erzeugt wird, wonach ein die Phasen der Kernspins streuendes Gradientenmagnetfeld angelegt wird, wonach ein nicht-selektiver 180°-Impuls und anschliessend ein selektiver 90°-Impuls beim Vorhandensein eines gleichen Gradientenmagnetfelds erzeugt werden. Beim efindungsgemässen Verfahren wird mit dem nicht-selektiven 90°-Impuls die Magnetisierung in einer Ebene quer zur Richtung des statischen einheitlichen Feldes gebracht. Das danach angelegte phasenstreuende Gradientenmagnetfeld bewirkt eine Phasenstreuung der Kernspinmagnetisierungen in dieser Ebene. Der Einfluss von Inhomogenitäten des statischen einheitlichen Magnetfeldes und die Streuung durch chemische Verschiebung (Chemical Shift $\sigma$) werden mit Hilfe eines nach dem phasenstreuenden Gradientenmagnetfeld erzeugten nicht-selektiven 180°-Impulses ausgeglichen. Das danach anzulegende Gradientenmagnetfeld dient zum Beseitigen der für den 180°-Impuls angebrachten Phasenstreuung. Mit dem selektiven 90°-Impuls wird die Magnetisierung der Kernspins in einer mit durch das Gradientenfeld bestimmten Schicht in ihre ursprüngliche oder in eine dazu entgegengesetzte Magnetisierungsrichtung zurückversetzt. Im Objekt ist in einer zuvor zu wählenden Schicht eine Magnetisierung in der Richtung (oder in der dazu entgegengesetzten Richtung) des einheitlichen, statischen Magnetfeldes erhalten. Ausserhalb dieser genannten Schicht ist die Phasierung der transversalen Magnetisierung völlig gestreut. Es sei bemerkt, dass bei einer Frequenz $f_0$ der nicht-selektiven 90°- und 180°-Hf-Impulse der selektive 90°-Hf-Impuls eine davon abweichende Frequenz $f_0+\Delta f$ haben kann, wodurch eine sog. "off-centre"-Anregung ausgeführt wird. Wenn das Gradientenmagnetfeld einen Gradienten in der x-Richtung hat, wird eine Schicht in einem Abstand von $\Delta x$ jener Schicht gewählt, die mit einem Hf-Impuls mit einer Frequenz $f_0$ angeregt wird, wobei gilt, dass

$$2\pi \cdot \Delta f = \gamma \cdot Gx \cdot \Delta x$$

ist. Weiter sei noch zu bemerken, dass die Anregung mit der abweichenden Frequenz $f_0+\Delta f$ in Phasenkohärenz mit den ersten und zweiten Hf-Impulsen mit der Frequenz $f_0$ erfolgen muss.

Ein Ausführungsbeispiel eines erfindungsgemässen Verfahrens ist dadurch gekennzeichnet, dass der Zyklus des nicht-selektiven 90°-Impulses,

des phasenverschiebenden Gradientenfeldes, des nicht-selektiven 180°- und des selektiven 90°-Impulses beim Vorhandensein eines gleichen Gradientenfeldes zumidest zweimal erfolgt, wobei bei jeder Durchführung das angelegte Gradientenmagnetfeld eine Gradientenrichtung hat, die quer zur Gradientenrichtung (zu den Gradientenrichtungen) des (der) zuvor angelegten Gradientenmagnetfeldes (Gradientenmagnetfelder) verläuft. Bei einem bevorzugten Ausführungsbeispiel des Verfahrens wird der Zyklus dreimal durchgeführt und ein würfelartiges Volumen in einem Objekt ausgewählt. Innerhalb des Würfels ist eine Magnetisierung in der (entgegengesetzten) Richtung des statischen einheitlichen Magnetfelds erzeugt, während ausserhalb des Würfels die Phasierung der transversalen Magnetisierung völlig gestreut ist. Nach einer weiteren Anregung erzeugen die Kernspins im Würfel ein Resonanzsignal, das durch die Gesamtheit der ausserhalb des Würfels befindlichen Kernspins nicht beeinflusst wird.

Das Verfahren nach dem bevorzugten Ausführungsbeispiel eignet sich insbesondere zum Betreiben volumenselektiver Spektrokopsie. Da bei diesen Messungen nur Signale eines ausgewählten Volumens erhalten werden, kann das statische einheitliche Magnetfeld in diesem Volumen sehr homogen sein, was die Möglichkeit zum Betreiben von Spektroskopie mit einer sehr hohen Spektralauflösung schafft.

Das erfindungsgemässe Verfahren eignet sich besonders zur Verwirklichung von Abbildungen mit hoher Auflösung, und in diesen Bildern werden Spindichte-Verteilungen und T1- und T2-Verteilungen wiedergegeben (T1 und T2 sind die longitudinale bzw. die transversale Relaxationszeitkonstante). Die Bestimmung einer transversalen Relaxationszeitkonstante geschieht wie folgt: Nach der Wahl zum Beispiel eines würfelförmigen Volumens werden ein 90°-Impuls und nach einer Wartezeit $\tau$ ein 180°-Impuls erzeugt, so dass nach einer Zeit $\tau$ ein Höchstwert des hierdurch erzeugten Echoimpulses auftritt. Durch die Wiederholung dieses Versuchs mit stets wechselnden Wartezeiten $\tau$ kann für das gewählte Volumen die Querrelaxationszeitkonstante $T_2$ bestimmt werden. Es ist klar, dass mehrere Abwandlungen des vorangehenden Verfahrens möglich sind (z.B. die Bestimmung einer $T_2$-Verteilung in einem gewählten volumen).

Die Erfindung gibt ebenfalls ein Verfahren zur Bestimmung der longitudinalen Zeitkonstante $T_1$ an. Hierbei wird zunächst ein 180°-Inversionsimpuls erzeugt, nach einer Wartezeit $\tau$ ein gewähltes Volumen nach einem oben beschriebenen Verfahren selektiert und nach einem 90°-Anregungsimpuls das erzeugte Resonanzsignal (FID-Signal) gemessen. Die merhmalige Wiederholung dieses Versuchs mit verschiedenen Wartezeiten $\tau$ ermöglicht die Bestimmung der longitudinalen Relaxationszeitkonstante. Bei der Herstellung von Abbildungen mit hoher Auflösung ist nur die Auswahl in einer Richtung erförderlich, wenn diese Richtung gleich der Richtung des Gradientenmagnetfelds in der Vorbereitungsphase eines Messzyklus ist, wie in der europäischen Patentanmeldung 0 046 782 beschrieben wurde. Da bei den erfindungsgemässen Verfahren stets Signale aus einem Teilvolumen empfangen werden, kann das statische Magnetfeld zuvor mittels Trimmspulen (shim coils) oder anderer Abgleichmittel sehr homogen gemacht werden, so dass dadurch auftretende Artefakte minimiert werden und auf diese Weise eine hohe Auflösung mölgich wird. Bei den erfindungsgemässen Verfahren kann mit Vorteil eine Oberflächenspule (surface coil) zum Detektieren von in einem scheiben-, stab- oder würfelförmigen Volumen erzeugten Resonanzsignalen verwendet werden.

Bei Verfahren nach dem Stand der Technik und bei den erfindungsgemässen Verfahren definiert man die Richtung des einheitlich statischen Feldes als Z-Achse, Die Feldrichtung der Gradientenmagnetfelder fällt mit der genannten Z-Achse zusammen. Die Gradientenrichtungen der drei häufig verschiedenen Gradientenmagnetfelder verlaufen in x-, y- bzw. z-Richtung. Die bei einem erfindungsgemässen Verfahren zu verwendenden 90°-Impulse sind beispielsweise x-Impulse, bei denen der selektiven 90°-Impuls ein −x-Impuls und der nicht-selektive 90°-Impuls ein +x-Impuls ist. Der nicht-selektive 180°-Impuls ist dabei ein y-Impuls. Vorzugsweise wird der nicht-selektive 180°-Impuls durch eine Zusammensetzung von Impulsen gebildet, und zwar einem 90°-x-Impuls, einem 180°-y-Impuls und einem 90°-x-Impuls (alle Impulse nicht-selektive). Die Verwendung und die Bezeichnung von 90°-x- und 180°-y-Impulsen ist an sich bekannt und beispielsweise in "Polarisation Transfer Sequences for Two Dimensional NMR by Heisenberg Vector Analyses", Journal of Magnetic Resonance 45, 8—29 (1981), von M. R. Bendall u.a., beschrieben.

Es hat sich vorteilhaft gezeigt, für den nicht-selektiven 90°-Impuls ein +x-Impuls und für den selektiven 90°-Impuls ein −x-Impuls (oder umgekehrt) zu verwenden, weil dann externe Einflüsse auf das selektierte Volumen infolge Störstellen im statischen Magnetfeld beseitigt werden.

Nach der Wahl eines ausgewählten Volumens im Objekt muss nach der Anregung dieses Volumens beispielsweise mit einem 90°-Anregungsimpuls auf übliche Weise ein Resonanzsignal konditioniert, gemessen, ein Echosignal aufgerugen werden usw. (siehe beispielsweise europäische Patentanmeldung 088.970).

**Patentansprüche**

1. Verfahren zum selektiven Anregen eines Volumens in einem Objekt, das in einem einheitlichen, statischen Magnetfeld angeordnet wird, wonach eleketromagnetische Hochfrequenzimpulse und Gradientenmagnetfelder zum selektiven Anregen des genannten Volumens erzeugt werden, dadurch gekennzeichnet, dass ein nicht-selektiver 90°-Impuls erzeugt wird, wonach ein die Kernspins in der Phase streuendes Gradientenmagnetfeld angelegt wird, wonach ein nicht-selektiver 180°-Impuls erzeugt und anschliessend ein selektiver 90°-Impuls bei Vorhandensein eines gleichen Gradientenfeldes erzeugt werden.

2. Verfahren nach Anspruch 1, dadurch gekennzeichnet, dass der Zyklus des nicht-selektiven 90°-Impulses, des phasenstreuenden Gradientenfeldes, des nicht-selektiven 180°- und des selektiven 90°-Impulses bei Vorhandensein eines gleichen Gradientenfeldes zumindest zweimal erfolgt, wobei bei jeder Durchführung das angelegte Gradientenmagnetfeld eine Gradientenrichtung hat, die quer zur (zu den) Gradientenrichtung(en) des (der) zuvor angelegten Gradientenmagnetfeldes (Gradientenmagnetfelder) verläuft.

3. Verfahren nach Anspruch 1 oder 2, dadurch gekennzeichnet, dass die 90°-Impulse x-Impulse sind.

4. Verfahren nach Anspruch 1, 2 oder 3, dadurch gekennzeichnet, dass die 180°-Impulse y-Impulse sind.

5. Verfahren nach Anspruch 1, 2 oder 3, dadurch gekennzeichnet, dass der 180°-Impuls aus einem 180°-y-Impuls zusammengesetzt ist, der von einem 90°-x-Impuls vorangegangen und von einem 90°-x-Impuls gefolgt wird.

6. Verfahren nach Anspruch 3, dadurch gekennzeichnet, dass der selektive 90°-Impuls ein −x-Impuls und der nicht-selektive 90°-Impuls ein +x-Impuls sind.

**Revendications**

1. Procédé pour exciter sélectivement un volume dans un objet, qui est disposé dans un champ magnétique statique uniforme, après quoi des impulsions électromagnétiques de haute fréquence et des champs magnétiques de gradient sont produits pour exciter sélectivement le volume cité, caractérisé en ce qu'une impulsion non sélective à 90° est produite, après quoi un champ magnétique de gradient dispersant les phases des spins nucléaires est appliqué, aprés quoi une impulsion non sélective à 180° et ensuite une impulsion sélective à 90° sont produites en présence d'un même champ magnétique de gradient.

2. Procédé suivant la revendication 1, caractérisé en ce que le cycle de l'impulsion non sélective à 90°, du champ de gradient dispersant les phases, de l'impulsion non sélective à 180° et de l'impulsion sélective à 90° a lieu au moins deux fois en présence d'un même champ de gradient, le champ magnétique de gradient imposé ayant à chaque exécution une direction de gradient qui est orientée perpendiculairement à la ou aux directions de gradient du ou des champs magnétiques de gradient imposés antérieurement.

3. Procédé suivant la revendication 1 ou 2, caractérisé en ce que les impulsions à 90° sont des impulsions en x.

4. Procédé suivant la revendication 1, 2 ou 3, caractérisé en ce que les impulsions à 180°, sont des impulsions en y.

5. Procédé suivant la revendication 1, 2 ou 3, caractérisé en ce que l'impulsion à 180° est composée d'une impulsion à 180° en y, qui est précédée d'une impulsion à 90° en x et suivie d'une impulsion à 90° en x.

6. Procédé suivant la revendication 3, caractérisé en ce que l'impulsion sélective à 90° est une impulsion en −x et l'impulsion non sélective à 90° est une impulsion en +x.

**Claims**

1. A method for the selective excitation of a volume in an object which is arranged in a uniform, static magnetic field, after which r.f. electromagnetic pulses and gradient magnetic fields are generated for the selective excitation of said volume, characterized in that a non-selective 90° pulse is generated, after which a gradient magnetic field which dephases the spin nuclei is applied, after which a non-selective 180° pulse is generated and subsequently a selective 90° pulse in the presence of a similar gradient field.

2. A method as claimed in Claim 1, characterized in that the cycle comprising the non-selective 90° pulse, the dephasing gradient field, the non-selective 180° pulse and the selective 90° pulse is executed at least twice in the presence of a similar gradient field, the gradient magnetic field applied during each execution having a gradient direction which extends transversely of the gradient direction (directions) of the previously applied gradient magnetic field (fields).

3. A method as claimed in Claim 1 or 2, characterized in that the 90° pulses are x-pulses.

4. A method as claimed in Claim 1, 2 or 3, characterized in that the 180° pulses are y-pulses.

5. A method as claimed in Claim 1, 2 or 3, characterized in that the 180° pulse is composed of a 180°-y-pulse which is preceded and succeeded by 90° x-pulse.

6. A method as claimed in Claim 3, characterized in that the selective 90° pulse is a −x-pulse, the non-selective 90° pulse being a +x-pulse.